# EUROPÄISCHE PATENTSCHRIFT

(11) **EP 2 702 083 B1**
(45) Veröffentlichungstag und Bekanntmachung des Hinweises auf die Patenterteilung: **14.01.2015**
(21) Anmeldenummer: 12712659.7
(22) Anmeldetag: 04.04.2012
(51) Int. Cl.: C08K 5/00, C08K 5/09, H01B 3/40, H01F 41/12, H01L 23/29, C08L 63/10, C08G 59/14, C09D 163/10, C08G 59/16

(54) **HARZ-ZUSAMMENSETZUNGEN ENTHALTEND MODIFIZIERTE EPOXIDHARZEN MIT SORBINSÄURE**
RESIN COMPOSITIONS COMPRISING MODIFIED EPOXY RESINS WITH SORBIC ACID
COMPOSITIONS DE RESINE COMPRENANT DES RESINES EPOXIDES MODIFIEES AVEC L'ACIDE SORBIQUE

(30) Priorität: 28.04.2011 DE 102011017708
(43) Veröffentlichungstag der Anmeldung: 05.03.2014
(73) Patentinhaber: Elantas GmbH, 46483 Wesel (DE)
(72) Erfinder: AL MASRI, Majdi, 21244 Buchholz (DE); HUESMANN, Anne-Gönke, 25693 Volsemenhusen (DE); LIENERT, Klaus-Wilhelm, 22763 Hamburg (DE); MORITZ, Hans-Ulrich, 21227 Bendestorf (DE)
(74) Vertreter: Schuck, Alexander
(86) Internationale Anmeldenummer: PCT/EP2012/056120
(87) Internationale Veröffentlichungsnummer: WO 2012/146469

(56) Entgegenhaltungen:
- WO-A1-2011/008295
- GB-A- 1 407 898
- GB-A- 1 464 287
- US-A- 3 876 432
- US-A- 3 980 483
- DATABASE CA [Online] CHEMICAL ABSTRACTS SERVICE, COLUMBUS, OHIO, US; 21. März 2008 (2008-03-21), NAKAZAWA, RYOSUKE ET AL: "Unsaturated polyester coating compositions with good dryability and application method of them", XP002679945, gefunden im STN Database accession no. 2008:348013 -& JP 2008 063528 A (KANSAI PAINT CO., LTD., JAPAN) 21. März 2008 (2008-03-21)

## Beschreibung

Die Erfindung betrifft Harz-Zusammensetzungen enthaltend Sorbinsäureester, diese enthaltende Überzugsmassen sowie deren Verwendung zum Isolieren von elektrischen und elektronischen Bauteilen und Geräten.

Gegenwärtig verwendete flüssige Standard-Zusammensetzungen für die Elektroisolation sind solche auf Basis von ungesättigten Polyestern (UP) oder Epoxidharzen (EP).

UP-Systeme, welche als Imprägnierharze zum Einsatz kommen, enthalten einen Reaktivverdünner wie beispielsweise Styrol und verursachen damit entsprechend hohe Monomer-Emissionen während der Aushärtung, oder sie sind monomerfrei mit der damit verbundenen höheren Viskosität. Die radikalische Polymerisation wird üblicherweise unter Verwendung eines thermischen Radikalstarters oder durch Bestrahlung mit UV-Licht eingeleitet.

Die zum Einsatz kommenden Epoxidharzsysteme werden kalt- oder heißgehärtet. Als Härterkomponente fungieren bei den kalthärtenden Systemen Polyamine und deren Derivate wie z.B. Polyamidoamine. Bei den heißhärtenden Systemen werden entweder Säureanhydride oder aber, bei der katalytischen Härtung, Lewis-Säuren, beispielsweise BCl₃-Amin-Komplexe, eingesetzt.

Eine umfangreichere Beschreibung von als Imprägnierharze verwendeten Polymeren findet sich in Horst Sulzbach (Herausgeber), "Polymers for Electrical Insulation", Verlag Moderne Industrie 2008, ISBN 978-3-937889-82-5 und den darin genannten weiteren Zitaten.

Epoxyvinylester weisen viele der vorteilhaften Eigenschaften von Epoxidharzsystemen wie gute Verarbeitbarkeit und Chemikalienbeständigkeit auf und können zudem in acrylischen Lösemitteln mit sehr niedrigen VOC-Gehalten verdünnt werden (VOC = volatile organic compounds, flüchtige organische Verbindungen). In US 5,984,647 wird die Verwendung solcher Systeme für die Imprägnierung eines hermetischen Motors beschrieben. Allerdings erreichen die Haftfestigkeiten dieser Systeme nicht die Werte, welche mit Epoxidharzsystemen prinzipiell möglich sind.

Die UV-Härtungseigenschaften von Epoxidharz-Zusammensetzungen mit nur teilweise umgesetzten Epoxygruppen werden von Saiki et al. im Journal of Applied Polymer Science 117 (2010) 3466 - 3472 und von Park et al. im International Journal of Adhesives & Adhesives 29 (2009) 710 - 717 beschrieben.

Aufgabe der Erfindung ist es, ein Imprägnierharzsystem bereitzustellen, welches gute Haftungseigenschaften aufweist, schnell aushärtet und nur geringe Mengen an VOC enthält.

Gelöst wird die Aufgabe durch eine Harz-Zusammensetzung enthaltend
a) das Umsetzungsprodukt aus
   a1) einer oder mehreren Epoxyverbindungen mit mindestens 2 Epoxygruppen, und
   a2) Sorbinsäure
   als Komponente A;
b) ein Vinylgruppen enthaltendes Lösungsmittel
   als Komponente B.

Überraschenderweise hat sich gezeigt, dass Sorbinsäureester enthaltende Harz-Zusammensetzungen sich als Imprägnierharze mit guten Haftfestigkeiten eignen. Die Systeme können durch Zusatz von Härtern gehärtet werden, wobei die entsprechenden Gelzeiten kurz sind. Die Imprägnierungen erscheinen homogen und zeichnen sich durch hohe Verbackungsfestigkeiten aus.

So werden erfindungsgemäß Harzsysteme für die Elektroisolation mit hervorragender Temperaturbeständigkeit, Haftung und elektrischen Isolierungseigenschaften im ausgehärteten Zustand bereitgestellt. Das Harz kann alleine oder in Kombination mit festen Isoliermaterialen (Bändern etc.) dazu verwendet werden, elektrische Geräte wie Motoren, Transformatoren und Generatoren zu isolieren.

Gelöst wird die Aufgabe weiterhin durch Überzugsmassen enthaltend
i) 100 Gew.-Teile der Harz-Zusammensetzung, und
ii) 1 bis 3 Gew.-Teile eines Radikale bildenden Polymerisationsinitiators.

Die erfindungsgemäßen Harz-Zusammensetzungen enthalten ein Umsetzungsprodukt aus einer oder mehreren Epoxy-funktionellen Verbindungen, die mindestens 2 Epoxygruppen aufweisen, und Sorbinsäure. Dieses Umsetzungsprodukt wird mit einem Vinylgruppen enthaltenden Lösungsmittel verdünnt.

Geeignete Epoxy-funktionelle Verbindungen mit mindestens 2 Epoxygruppen sind beispielsweise Bisphenol-A-Diglycidylether der nachstehenden Formel, 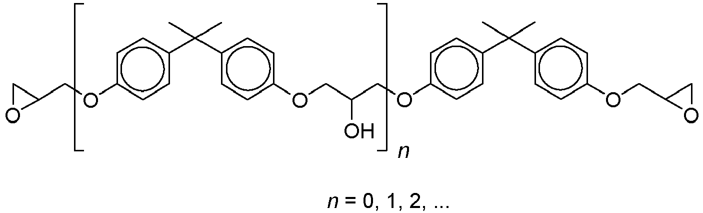 wobei n im Bereich von 0 bis 10, bevorzugt 0 bis 8, besonders bevorzugt 0 bis 6 liegt, oder Bisphenol-F-Diglycidylether der nachstehenden Formel, 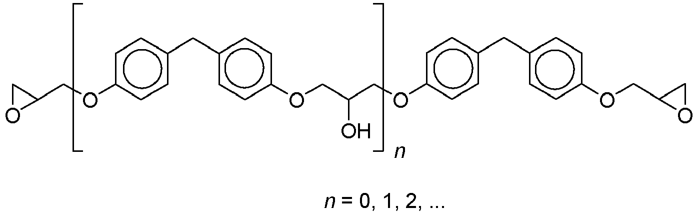 wobei n im Bereich von 0 bis 5, bevorzugt 0 bis 4, besonders bevorzugt 0 bis 3 liegt.

Weiterhin als Epoxy-funktionelle Verbindungen mit mindestens 2 Epoxygruppen eignen sich zum Beispiel Epoxyverbindungen auf Basis von Phenolnovolak oder Kresolnovolak. Geeignete Epoxynovolake weisen im Allgemeinen einen Schmelzpunkt im Bereich von 60 bis 120 °C, bevorzugt 70 bis 100 °C, auf und enthalten pro Molekül im Mittel 2 bis 20, bevorzugt 3 bis 10 Epoxygruppen.

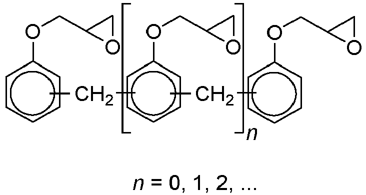

Als Epoxy-funktionelle Verbindungen mit mindestens 2 Epoxygruppen bevorzugt sind der Bisphenol-A-Diglycidylether mit n = 0 sowie dessen höhermolekulare Homologe.

Geeignete Vinylgruppen enthaltende Lösungsmittel - auch als Reaktivverdünner bezeichnet - sind monofunktionelle, difunktionelle und polyfunktionelle Reaktivverdünner. Beispiele für Reaktivverdünner sind Acrylate, Methacrylate und Vinylether. Insbesondere bevorzugt sind (Meth)acrylate.

Geeignete Acrylate und Methacrylate sind im Allgemeinen die (Meth)acrylate von Monoalkoholen, Diolen und Polyolen. Bevorzugt sind die (Meth)acrylate von Monoalkoholen, beispielsweise Hydroxyethyl(meth)acrylat, Hydroxypropyl(meth)acrylat, Butyl-(meth)acrylat, Hexyl(meth)acrylat, Octyl(meth)acrylat, und die (Meth)acrylate von Diolen, beispielsweise Butandioldi(meth)acrylat, Hexandioldi(meth)acrylat, Diethylenglykoldi-(meth)acrylat, Triethylenglykoldi(meth)acrylat, Dipropylenglykoldi(meth)acrylat und Tripropylenglykoldi(meth)acrylat.

Ungesättigte Polyesterharze sind an sich bekannt und werden durch die Reaktion von Polyolen, mehrfunktionellen ungesättigten Carbonsäuren und gegebenenfalls monofunktionellen Verbindungen als Kettenabbrecher hergestellt. Die Herstellung der ungesättigten Polyesterharze ist allgemein bekannt. Dabei werden die Komponenten mit oder ohne Veresterungskatalysatoren üblicherweise auf Temperaturen zwischen 160 und 200 °C erhitzt. Die Reaktion wird üblicherweise unter Schutzgas durchgeführt. Das bei der Kondensationsreaktion gebildete Wasser kann unter Verwendung eines geeigneten Lösungsmittels azeotrop abdestilliert oder durch Vakuumdestillation abgetrennt werden. Der Reaktionsfortschritt wird üblicherweise durch Bestimmung der Säurezahl und/oder der Viskosität kontrolliert.

Zur Herstellung der ungesättigten Polyester bevorzugte Polyole sind ausgewählt aus Ethylenglykol, 1,3-Propandiol, 2-Methyl-1,3-propandiol, Di- und Triethylenglykol, Neopentylglykol, 1,3- und 1,6-Hexandiol, Perhydrobisphenol-A, Glycerin, Trimethylolpropan, Tris-(2-hydroxyethyl)isocyanurat, Pentaerythrit und Dipentaerythrit. Bevorzugt sind Diund Triethylenglykol, 2-Methyl-1,3-propandiol, Glycerin, Neopentylglykol und Trimethylolpropan.

Zur Herstellung der ungesättigten Polyester bevorzugte ungesättigte Carbonsäuren sind a,β-ungesättigte Dicarbonsäuren und deren Anhydride wie Maleinsäure, Maleinsäureanhydrid und Fumarsäure. Bevorzugt sind weiterhin Gemische von α,β-ungesättigten Dicarbonsäuren mit weiteren, modifizierend wirkenden Dicarbonsäuren, bevorzugt mit gesättigten aliphatischen oder aromatischen Dicarbonsäuren und deren Anhydriden wie Adipinsäure, Bernsteinsäure, Phthalsäureanhydrid, Isophthalsäure, Terephthalsäure und 2,6-Naphthalindicarbonsäure. Bevorzugt sind Maleinsäureanhydrid und Gemische aus Maleinsäureanhydrid und Adipinsäure.

Als Kettenabbrecher werden im Allgemeinen monofunktionelle Carbonsäuren oder monofunktionelle Alkohole mitverwendet, beispielsweise Tallölfettsäure, Benzoesäure, 2-Ethylhexansäure, Hexanol, 2-Ethylhexanol, Benzylalkohol, tert.-Butanol und Isoprenol (3-Methyl-3-buten-1-ol). Bevorzugt werden Hexanol, Isoprenol sowie das Reaktionsprodukt von Tetrahydrophthalsäureanhydrid mit Ethanolamin als Kettenabbrecher mit umgesetzt.

Die ungesättigten Polyesterharze können mit endständigen oder kettenständigen Imidgruppen modifiziert sein. Endständige Imidgruppen können beispielsweise durch Umsetzung mit dem Reaktionsprodukt aus Tetrahydrophthalsäureanhydrid und Ethanolamin eingeführt werden. Diese und weitere geeignete monofunktionelle, Imidgruppen aufweisende Verbindungen, die als Kettenabbrecher fungieren, sind in DE-A 1 570 273 beschrieben.

Kettenständige Imidgruppen können beispielsweise durch Umsetzung mit Imidgruppen enthaltenden Verbindungen eingeführt werden. Diese werden durch Reaktion zwischen Verbindungen erhalten, von denen die eine Verbindung eine Carbonsäureanhydrid-Gruppe sowie eine weitere funktionelle Gruppe aufweist, während die andere Verbindung eine primäre Aminogruppe und eine weitere funktionelle Gruppe aufweist. Diese weiteren funktionellen Gruppen sind solche, die mit den Polyol- oder Polycarbonsäure-Komponenten des ungesättigten Polyesterharzes unter Einbau in die Polymerkette reagieren können. Im Allgemeinen handelt es sich bei diesen weiteren funktionellen Gruppen um Carbonsäuregruppen oder Hydroxylgruppen. Es können aber auch primäre Aminogruppen oder Carbonsäureanhydridgruppen als weitere funktionelle Gruppen in diesen Verbindungen vorliegen. Geeignete Verbindungen sind in DE 1 720 323 beschrieben.

Geeignete Verbindungen mit einer Carbonsäureanhydrid-Gruppe und einer weiteren funktionellen Gruppe sind Pyromellitsäuredianhydrid und Trimellitsäureanhydrid. Es kommen jedoch auch andere aromatische Carbonsäureanhydride in Frage, beispielsweise die Naphthalintetracarbonsäuredianhydride oder Dianhydride von Tetracarbonsäuren mit zwei Benzolkernen, bei denen die Carboxylgruppen in 3,3',4- und 4'-Stellung stehen.

Beispiele für Verbindungen mit primären Aminogruppen sind insbesondere diprimäre Diamine, z.B. Ethylendiamin, Tetramethylendiamin, Hexamethylendiamin, Nonamethylendiamin und andere aliphatische diprimäre Diamine.

Ferner kommen aromatische diprimäre Diamine, wie Benzidin, Diaminodiphenylmethan, Diaminodiphenylsulfon, -sulfoxid, -ether und -thioether, Phenylendiamine, Toluylendiamine sowie Diamine mit drei Benzolkernen im Molekül, z.B. Bis(4-aminophenoxy)-1,4-benzol in Betracht.

In Frage kommen schließlich cycloaliphatische Diamine wie 4,4'-Dicyclohexylmethandiamin.

Beispielsweise können Imidgruppen durch Umsetzung mit Verbindungen, die durch Reaktion von 1 mol Trimellitsäureanhydrid und 2 mol der genannten diprimären Diamine erhältlich sind, in die Polymerkette eingeführt werden.

Als aminogruppenhaltige Verbindungen mit einer weiteren funktionellen Gruppe sind Aminoalkohole geeignet, z.B. Monoethanolamin und Monopropanolamine, weiterhin Aminocarbonsäuren wie Glycin, Aminopropansäure, Aminocapronsäuren oder Aminobenzoesäuren.

Beispielsweise können Imidgruppen auch durch Umsetzung mit Verbindungen, die durch Reaktion von 1 mol Pyromellitsäuredianhydrid und 2 mol der genannten Aminoalkohole oder Aminocarbonsäuren erhältlich sind, in die Polymerkette eingeführt werden. Beispielsweise können Imidgruppen auch durch Umsetzung mit Verbindungen, die durch Reaktion von 1 mol Trimellitsäureanhydrid mit 1 mol der genannten Aminocarbonsäuren erhältlich sind, in die Polymerkette eingeführt werden.

Als Styrolderivate eignen sich beispielsweise an der Doppelbindung oder am Kern substituierte Styrole wie alpha-Methylstyrol, Vinyltoluol oder tert.-Butylstyrol.

Trifunktionelle oder mehrfunktionelle Reaktivverdünner können auch zusammen mit difunktionellen Reaktivverdünnern zur Erhöhung der Vernetzungsdichte eingesetzt werden.

Geeignete polyfunktionelle Reaktivverdünner sind beispielsweise die (Meth)acrylsäureester von Trimethylolpropan, Pentaerythritol oder Dipentaerythritol, oder die Allylalkoholester von Trimellit- oder Pyromellitsäure.

Die Epoxy-funktionellen Verbindungen werden in Gegenwart eines Veresterungskatalysators mit Sorbinsäure bei Temperaturen von im Allgemeinen 60 bis 140 °C, vorzugsweise 80 bis 120 °C umgesetzt. Geeignete Veresterungskatalysatoren sind zum Beispiel Triethylamin, Dimethylbenzylamin, Imidazol, Triphenylphosphin, Triphenylantimon, Tetrabutylammoniumchlorid oder Chrom(III)diisopropylsalicylat.

Um zu verhindern, dass die Doppelbindungen der Sorbinsäure(estergruppen) im Rahmen der Veresterungsreaktion vorzeitig miteinander reagieren, können Inhibitoren zugesetzt werden. Als Inhibitoren eignen sich beispielsweise alkylierte Phenole, Hydrochinone oder Chinone. Bevorzugt ist Hydrochinon.

Die Veresterung kann in einem Lösungsmittel durchgeführt werden. Geeignete Lösungsmittel sind zum Beispiel Dimethylformamid, Cyclohexan oder aromatische Lösungsmittel wie Toluol, Ethylbenzol, Xylol, Cumol, Solventnaphta®, Schwerbenzol, verschiedene Solvesso®-Typen, verschiedene Shellsol®-Typen oder Deasol®. Bevorzugt ist Toluol. Das Lösungsmittel wird nach Beendigung der Reaktion entfernt, vorzugsweise mittels Destillation im Vakuum.

Im Allgemeinen enthalten die erfindungsgemäßen Harz-Zusammensetzungen 10 bis 100 Gew.-%, bevorzugt 30 bis 70 Gew.-%, insbesondere bevorzugt 40 bis 60 Gew.-% Umsetzungsprodukt aus Epoxyverbindung und Sorbinsäure (Komponente A) und 0 bis 90 Gew.-%, bevorzugt 30 bis 70 Gew.-%, insbesondere bevorzugt 40 bis 60 Gew.-% Vinylgruppen enthaltendes Lösungsmittel (Reaktivverdünner, Komponente B), wobei die Summe der Komponenten A und B 100 Gew.-% ergibt.

Zur Unterbindung einer vorzeitigen Härtung der Harz-Zusammensetzungen können Stabilisatoren zugesetzt werden. Als Stabilisatoren eignen sich beispielsweise alkylierte Phenole, Hydrochinone oder Chinone. Bevorzugt ist p-Benzochinon.

In einer bevorzugten Ausführungsform der Erfindung ist die Harz-Zusammensetzung dadurch gekennzeichnet, dass die in der Komponente A enthaltenen Epoxygruppen vollständig mit Sorbinsäure umgesetzt werden.

Eine vollständige Umsetzung der in der Komponente A enthaltenen Epoxygruppen mit Sorbinsäure bedeutet im Sinne der Erfindung, dass mindestens 95%, bevorzugt 98%, besonders bevorzugt 99% und ganz besonders bevorzugt 100% der in der Komponente A enthaltenen Epoxygruppen mit Sorbinsäure umgesetzt werden.

Die Harz-Zusammensetzungen gemäß der bevorzugten Ausführungsform enthalten Sorbinsäureestergruppen und werden gehärtet, indem die Doppelbindungen der Sorbinsäureestergruppen mittels eines durch Hitze oder UV-Licht aktivierbaren, Radikale bildenden Polymerisationsinitiators vernetzt werden. Im Allgemeinen werden diese Initiatoren in Mengen von 1 bis 3 Gew.-%, bezogen auf die Harz-Zusammensetzung, eingesetzt.

Geeignete Radikale bildende Polymerisationsinitiatoren sind die dem Fachmann bekannten Polymerisationsinitiatoren.

Bevorzugte mittels UV-Licht aktivierbare Polymerisationsinitiatoren sind 4,4'-Dimethylbenzylketal, 4,4'-Dimethoxybenzoin, Benzoinmethylether und 2,4,6-Trimethylbenzoyldiphenylphosphinoxid.

Bevorzugte mittels Hitze aktivierbare Polymerisationsinitiatoren sind Dicumylperoxid, Di-tert.-Butylperoxid und tert.-Butylperbenzoat.

Die erfindungsgemäßen Harz-Zusammensetzungen werden mittels dem Fachmann bekannter Methoden in die Wicklung einer Elektromaschine eingebracht. Geeignete Methoden zur Imprägnierung sind zum Beispiel die Imprägnierung durch Tauchen, Tauchrollieren, Träufeln oder Gießen, die Vakuumimprägnierung oder die Vakuum-Druck-Imprägnierung. Die Härtung kann beispielsweise thermisch in einem Ofen oder durch die in einer Wicklung erzeugte Stromwärme erfolgen. Darüber hinaus kann durch Bestrahlung mit UV-Licht auf dem Blechpaket gehärtet werden. Eine Kombination verschiedener Methoden zur Härtung ist ebenfalls möglich. Ein Beispiel hierfür ist die Kombination aus Stromwärme und Bestrahlung.

Weiterhin Gegenstand der Erfindung ist die Verwendung der Harz-Zusammensetzungen und der Überzugsmassen zum Isolieren von elektrischen und elektronischen Bauteilen und Geräten. Die Erfindung betrifft insbesondere die Verwendung der Zusammensetzungen und Überzugsmassen zum Imprägnieren von elektrischen Wicklungen, beispielsweise von Rotoren, Statoren, Transformatoren und Drosselspulen.

Die Erfindung wird durch die nachstehenden Beispiele näher erläutert.

### Beispiele

### Beispiel 1

Ein Dreihalskolben mit Thermometer, Rührer und Rückflusskühler wird beschickt mit 600 g eines (im Vergleich zu Beispiel 2 niedermolekularen) Bisphenol-A-Diglycidylethers (Epoxyäquivalent von 184-190 g), 350 g Sorbinsäure, 14,6 g Dimethylbenzylamin und 2 g Hydrochinon. Das Gemisch wird bei 100 °C unter Stickstoff so lange erhitzt, bis das Gemisch eine Säurezahl unterhalb von 1 mg KOH/g aufweist.

### Beispiel 2

Ein Dreihalskolben mit Thermometer, Rührer und Rückflusskühler wird beschickt mit 900 g eines (im Vergleich zu Beispiel 1 höhermolekularen) Bisphenol-A-Diglycidylethers (Epoxyäquivalent von 806-909 g), 125 g Sorbinsäure, 21 g Dimethylbenzylamin, 3 g Hydrochinon und 270 g Toluol. Das Gemisch wird bei 100 °C unter Stickstoff so lange erhitzt, bis das Gemisch eine Säurezahl unterhalb von 5 mg KOH/g aufweist. Das Lösungsmittel Toluol wird durch Destillation im Vakuum entfernt.

### Beispiel 3

Ein Dreihalskolben mit Thermometer, Rührer und Rückflusskühler wird beschickt mit 600 g Bisphenol-F-Diglycidylether, 396 g Sorbinsäure, 14,6 g Dimethylbenzylamin und 2 g Hydrochinon. Das Gemisch wird bei 100 °C unter Stickstoff so lange erhitzt, bis das Gemisch eine Säurezahl unterhalb von 1 mg KOH/g aufweist.

### Beispiel 4

Ein Dreihalskolben mit Thermometer, Rührer und Rückflusskühler wird beschickt mit 480 g eines Phenolnovolak-Glycidylethers (Epoxyäquivalent 174,3 g), 307,8 g Sorbinsäure, 14,6 g Dimethylbenzylamin, 1,6 g Hydrochinon und 200 g Toluol. Das Gemisch wird bei 110 °C unter Stickstoff so lange erhitzt, bis das Gemisch eine Säurezahl unterhalb von 1 mg KOH/g aufweist.

### Beispiel 5

500 g Harz aus Beispiel 1, 500 g Hydroxyethylmethacrylat und 0,001 g p-Benzochinon werden miteinander gemischt. Das entsprechende Tränkharz zeigt eine Viskosität von 290 mPa·s bei 23 °C. Mit 2 Gew.-% tert.-Butylperbenzoat bei 120 °C beträgt die Gelzeit 3 min.

Die Gelzeit wird nach DIN 16945 bestimmt.

### Beispiele 6 und 7

Die Harze aus den Beispielen 6 und 7 werden, wie in Beispiel 5 beschrieben, mit den in der Tabelle 1 aufgeführten Methacrylaten hergestellt.

**Tabelle 1**

| Beispiel | 5 | 6 | 7 |
|---|---|---|---|
| | | | |
| Harz aus Beispiel 1 in g | 500 | 500 | 500 |
| Hydroxyethylmethacrylat in g | 500 | | |
| Hydroxypropylmethacrylat in g | | 500 | |
| Triethylenglykoldimethacrylat in g | | | 500 |
| | | | |
| Viskosität in mPa·s bei 23 °C | 290 | 600 | 700 |
| Gelzeit mit 2 Gew.-% tert.-Butylperbenzoat bei 120 °C in min | 3,0 | 3,4 | 2,5 |

Das Harz aus Beispiel 7 hat eine Verbackungsfestigkeit von 400 N bei 23 °C und 130 N bei 155 °C.

Die Verbackungsfestigkeit wird nach IEC 61033 bestimmt.

### Beispiel 8

Aus 308 g Maleinsäureanhydrid, 114 g Adipinsäure, 92 g Hexandiol, 72 g Glycerin, 409 g Hexanol und 0,3 g Hydrochinon wird ein ungesättigter Polyester hergestellt, der eine Säurezahl unterhalb von 20 mg KOH/g aufweist.

Dieser ungesättigte Polyester wird mit dem Harz aus Beispiel 1 im Verhältnis 1:1 gemischt. Das entsprechende Tränkharz wird mit 0,001% p-Benzochinon stabilisiert und zeigt eine Viskosität von 17800 mPa·s bei 23 °C. Mit 2 Gew.-% tert.-Butylperbenzoat bei 120 °C beträgt die Gelzeit 7,5 min.

Das Harz aus Beispiel 8 hat eine Verbackungsfestigkeit von 190 N bei 23 °C und 50 N bei 155 °C.

### Beispiel 9

500 g Harz aus Beispiel 2, 500 g Triethylenglykoldimethacrylat und 0,001 g p-Benzochinon werden miteinander gemischt. Das entsprechende Tränkharz zeigt eine Viskosität von 12800 mPa·s bei 23 °C. Mit 2 Gew.-% tert.-Butylperbenzoat bei 120 °C beträgt die Gelzeit 2,5 min.

Das Harz aus Beispiel 9 hat eine Verbackungsfestigkeit von 470 N bei 23 °C und 57 N bei 155 °C.

### Beispiel 10

500 g Harz aus Beispiel 4, 500 g Triethylenglykoldimethacrylat und 0,001 g p-Benzochinon werden miteinander gemischt. Das entsprechende Tränkharz zeigt eine Viskosität von 980 mPa·s bei 23 °C. Mit 2 Gew.-% tert.-Butylperbenzoat bei 120 °C beträgt die Gelzeit 2,5 min.

Das Harz aus Beispiel 10 hat eine Verbackungsfestigkeit von 450 N bei 23 °C und 170 N bei 155 °C.

### Beispiel 11

450 g Harz aus Beispiel 1, 50 g Harz aus Beispiel 4, 500 g Hydroxypropylmethacrylat und 0,001 g p-Benzochinon werden miteinander gemischt. Das entsprechende Tränkharz zeigt eine Viskosität von 480 mPa·s bei 23 °C. Mit 2 Gew.-% tert.-Butylperbenzoat bei 120 °C beträgt die Gelzeit 3,75 min.

Das Harz aus Beispiel 11 hat eine Verbackungsfestigkeit von 300 N bei 23 °C und 95 N bei 155 °C.

Mit den Harzen aus den Beispielen 5 bis 11 wurden Kupferwicklungen enthaltende Statoren der Baugröße 90 getränkt. Im Falle der Harze aus den Beispielen 8 und 9 wurde das Harz auf 40 °C vorgewärmt, und damit wurden dann die Statoren getränkt. Nach einer Abtropfphase von 20 min wurden die Harze zwei Stunden bei 160 °C gehärtet. Anschließend wurden die Statoren aufgesägt. Alle Statoren zeigten eine lunkerfreie Durchimprägnierung der Kupferwicklungen.

## Patentansprüche

1. Verwendung einer Harz-Zusammensetzung enthaltend
a) das Umsetzungsprodukt aus
a1) einer oder mehreren Epoxyverbindungen mit mindestens 2 Epoxygruppen, und
a2) Sorbinsäure
als Komponente A;
b) ein Vinylgruppen enthaltendes Lösungsmittel
als Komponente B;
zum Isolieren von elektrischen und elektronischen Bauteilen und Geräten.

2. Verwendung nach Anspruch 1, **dadurch gekennzeichnet, dass** in der Komponente A die Epoxygruppen vollständig mit Sorbinsäure umgesetzt werden.

3. Verwendung nach einem der Ansprüche 1 oder 2, **dadurch gekennzeichnet, dass** in Komponente A ein Bisphenol-A-Diglycidylether als Epoxyverbindung a1) umgesetzt wird.

4. Verwendung nach einem der Ansprüche 1 oder 2, **dadurch gekennzeichnet, dass** in Komponente A ein Bisphenol-F-Diglycidylether als Epoxyverbindung a1) umgesetzt wird.

5. Verwendung nach einem der Ansprüche 1 oder 2, **dadurch gekennzeichnet, dass** in Komponente A ein Epoxynovolak als Epoxyverbindung a1) umgesetzt wird.

6. Verwendung nach einem der Ansprüche 1 bis 5, **dadurch gekennzeichnet, dass** das Vinylgruppen enthaltende Lösungsmittel der Komponente B ausgewählt ist aus der Gruppe bestehend aus Acrylaten von Monoalkoholen, Diolen und Polyolen, aus Methacrylaten von Monoalkoholen, Diolen und Polyolen.

7. Verwendung einer Überzugsmasse enthaltend
i) 100 Gew.-Teile einer Harz-Zusammensetzung gemäß einem der Ansprüche 1 bis 6, und
ii) 1 bis 3 Gew.-Teile eines Radikale bildenden Polymerisationsinitiators, zum Isolieren von elektrischen und elektronischen Bauteilen und Geräten.

8. Harz-Zusammensetzung enthaltend
a) das Umsetzungsprodukt aus
a1) einer oder mehreren Epoxyverbindungen mit mindestens 2 Epoxygruppen, und
a2) Sorbinsäure
als Komponente A;
b) ein Vinylgruppen enthaltendes Lösungsmittel
als Komponente B;
**dadurch gekennzeichnet, dass** in Komponente A ein Bisphenol-F-Diglycidylether oder ein Epoxynovolak als Epoxyverbindung a1) umgesetzt wird.

9. Harz-Zusammensetzung nach Anspruch 8, **dadurch gekennzeichnet, dass** in der Komponente A die Epoxygruppen vollständig mit Sorbinsäure umgesetzt werden.

10. Harz-Zusammensetzung nach Anspruch 8 oder 9, **dadurch gekennzeichnet, dass** das Vinylgruppen enthaltende Lösungsmittel der Komponente B ausgewählt ist aus der Gruppe bestehend aus Acrylaten von Monoalkoholen, Diolen und Polyolen aus Methacrylaten von Monoalkoholen, Diolen und Polyolen.

11. Überzugsmasse enthaltend
i) 100 Gew.-Teile einer Harz-Zusammensetzung gemäß einem der Ansprüche 8 bis 10, und
ii) 1 bis 3 Gew.-Teile eines Radikale bildenden Polymerisationsinitiators.

## Claims

1. Use of a resin composition comprising
a) the reaction product of
a1) one or more epoxy compounds having at least 2 epoxy groups,
and
a2) sorbic acid
as component A;
b) a solvent containing vinyl groups as component B;
for insulation of electrical and electronic components and devices.

2. Use according to Claim 1, **characterized in that** the epoxy groups in component A are reacted fully with sorbic acid.

3. Use according to either of Claims 1 and 2, **characterized in that** a bisphenol A diglycidyl ether is reacted as the epoxy compound a1) in component A.

4. Use according to either of Claims 1 and 2, **characterized in that** a bisphenol F diglycidyl ether is reacted as the epoxy compound a1) in component A.

5. Use according to either of Claims 1 and 2, **characterized in that** an epoxy novolac is reacted as the epoxy compound a1) in component A.

6. Use according to any of Claims 1 to 5, **characterized in that** the solvent containing vinyl groups in component B is selected from the group consisting of acrylates of monoalcohols, diols and polyols, and of methacrylates of monoalcohols, diols and polyols.

7. Use of a coating composition comprising
i) 100 parts by weight of a resin composition according to any of Claims 1 to 6, and
ii) 1 to 3 parts by weight of a free-radical-forming polymerization initiator
for insulation of electrical and electronic components and devices.

8. Resin composition comprising
a) the reaction product of
a1) one or more epoxy compounds having at least 2 epoxy groups,
and
a2) sorbic acid
as component A;
b) a solvent containing vinyl groups as component B;
**characterized in that** a bisphenol F diglycidyl ether or an epoxy novolac is used as epoxy compound a1) in component A.

9. Resin composition according to Claim 8, **characterized in that** the epoxy groups in component A are reacted fully with sorbic acid.

10. Resin composition according to Claim 8 or 9, **characterized in that** the solvent containing vinyl groups in component B is selected from the group consisting of acrylates of monoalcohols, diols and polyols, and of methacrylates of monoalcohols, diols and polyols.

11. Coating composition comprising
i) 100 parts by weight of a resin composition according to any of Claims 8 to 10, and
ii) 1 to 3 parts by weight of a free-radical-forming polymerization initiator.

## Revendications

1. Utilisation d'une composition de résine contenant:
a) le produit de réaction de
a1) un ou plusieurs composés époxy contenant au moins 2 groupes époxy et
a2) de l'acide sorbique
en tant que composant A ;
b) un solvant contenant des groupes vinyle en tant que composant B ;
pour l'isolation de composants et d'appareils électriques et électroniques.

2. Utilisation selon la revendication 1, **caractérisée en ce que**, dans le composant A, les groupes époxy sont entièrement transformés avec l'acide sorbique.

3. Utilisation selon l'une quelconque des revendications 1 ou 2, **caractérisée en ce que**, dans le composant A, un éther diglycidylique de bisphénol A est mis en réaction en tant que composé époxy a1).

4. Utilisation selon l'une quelconque des revendications 1 ou 2, **caractérisée en ce que**, dans le composant A, un éther diglycidylique de bisphénol F est mis en réaction en tant que composé époxy a1).

5. Utilisation selon l'une quelconque des revendications 1 ou 2, **caractérisée en ce que**, dans le composant A, une époxy-novolaque est mise en réaction en tant que composé époxy a1).

6. Utilisation selon l'une quelconque des revendications 1 à 5, **caractérisée en ce que**, le solvant contenant des groupes vinyle du composant B est choisi dans le groupe constitué par les acrylates de monoalcools, de diols et de polyols, les méthacrylates de monoalcools, de diols et de polyols.

7. Utilisation d'un matériau de revêtement contenant :
i) 100 parties en poids d'une composition de résine selon l'une quelconque des revendications 1 à 6 et
ii) 1 à 3 parties en poids d'un initiateur de polymérisation formant des radicaux,
pour l'isolation de composants et d'appareils électriques et électroniques.

8. Composition de résine contenant :
a) le produit de réaction de
a1) un ou plusieurs composés époxy contenant au moins 2 groupes époxy et
a2) de l'acide sorbique
en tant que composant A ;
b) un solvant contenant des groupes vinyle en tant que composant B ;
**caractérisée en ce que**, dans le composant A, un éther diglycidylique de bisphénol F ou une époxy-novolaque est mis en réaction en tant que composé époxy a1).

9. Composition de résine selon la revendication 8, **caractérisée en ce que**, dans le composant A, les groupes époxy sont entièrement transformés avec l'acide sorbique.

10. Composition de résine selon la revendication 8 ou 9, **caractérisée en ce que** le solvant contenant des groupes vinyle du composant B est choisi dans le groupe constitué par les acrylates de monoalcools, de diols et de polyols, les méthacrylates de monoalcools, de diols et de polyols.

11. Matériau de revêtement contenant :
i) 100 parties en poids d'une composition de résine selon l'une quelconque des revendications 8 à 10 et
ii) 1 à 3 parties en poids d'un initiateur de polymérisation formant des radicaux.
